**Europäisches Patentamt**

**European Patent Office**

**Office européen des brevets**

(19)

(11) Veröffentlichungsnummer: **0 064 660**
**A2**

(12) **EUROPÄISCHE PATENTANMELDUNG**

(21) Anmeldenummer: **82103527.6**

(22) Anmeldetag: **27.04.82**

(51) Int. Cl.³: **G 09 B 19/00**
**H 05 K 13/00**

(30) Priorität: **30.04.81 DE 3117879**
**29.08.81 DE 3134226**

(43) Veröffentlichungstag der Anmeldung:
**17.11.82 Patentblatt 82/46**

(84) Benannte Vertragsstaaten:
**CH FR GB IT LI SE**

(71) Anmelder: **Wittchow, Dieter**
**Hausotterstrasse 26**
**D-1000 Berlin 51(DE)**

(72) Erfinder: **Wittchow, Dieter**
**Hausotterstrasse 26**
**D-1000 Berlin 51(DE)**

(54) Verfahren und Einrichtung zur rationellen, kontrollierten Steuerung von Arbeitsabläufen beim Zusammenbau von elektronischen und mechanischen Baugruppen, insbesondere der Bestückung von Schaltungsträgerplatinen.

(57) Auf einem Display werden Hinweise gegeben, welche den Bestückungsvorgang Schritt für Schritt mit Symbolen und Text beschreiben (programmierte Unterweisung). Display und Trägerplatte sind nach ergonomischen Gesichtpunkten im Blickfeld der Bedienungsperson angeordnet. Verwendet wird ein Display mit hoher Auflösung. Der Arbeitsablauf auf dem Display wird in den jeweiligen optimalen Arbeitsschritten wiedergegeben. Es wird dem Auge nicht nur erleichtert, den jeweiligen Bestückungsort zu finden, sondern der Fortgang der Arbeiten kann auf dem Bildschirm im Detail verfolgt werden (Prinzip des sich aufbauenden Bildes). Die jeweilige Bestückungsposition leuchtet heller auf als die bereits bestuckten Positionen. Die Steuerung erfolgt über einen Grafik-Mikrocomputer. Die Bauteilezufuhr geschieht automatisch und wird ebenfalls vom Programm gesteuert. Die Überwachung der Montage kann durch die Einmischung eines Kamera-Bildes vom Arbeitsobjekt in das symbolhafte Bild der Beschreibung des Arbeitsablaufs auf dem Display erfolgen. Mit dieser Methode ist jederzeit eine direkte Kontrolle der Ordnungsmäßigkeit der aktuellen Arbeiten möglich. Mit geeigneter Optik kann das Symbolbild des Displays - nach Art des Bestuckungsaufdrucks bei Leiterplatten - auf das Arbeitsobjekt projiziert werden.

EP 0 064 660 A2

## Verfahren zur rationellen, kontrollierten Steuerung von Arbeitsabläufen beim Zusammenbau von elektronischen und mechanischen Baugruppen, insbesondere der Bestückung von Schaltungsträgerplatinen

Das erfindungsgemäß vorgeschlagene Verfahren arbeitet nach dem Prinzip der programmierten Unterweisung und ist geeignet, Arbeitsabläufe wie das Bestücken von Trägerplatten, den Zusammenbau von elektrischen und mechanischen Baugruppen sowie anderen Produkten zu steuern. Die Erfindung betrifft ein Verfahren, bei dem auf dem Display eines Grafik-Mikrocomputers detaillierte Hinweise gegeben werden, welche den Bestückungsvorgang Schritt für Schritt mit Symbolen und Text beschreiben. Im Gegensatz zu den bekannten Verfahren erfolgt die Anzeige/Markierung nicht direkt auf der Trägerplatte. Display und Trägerplatte (Arbeitsobjekt) sind nach ergonomischen Gesichtspunkten im Blickfeld der Bedienungsperson angeordnet, so, daß ein relativ ermüdungsarmer Arbeitsablauf gewährleistet ist. Verwendet wird ein handelsübliches schwarz-weiß bzw. zur Farbwiedergabe geeignetes Display mit relativ hoher Auflösung.

Gegenüber dem Stand der Technik, nämlich einmal der Bestückung nach Lageplan, sind die Vorteile darin zu sehen, daß der Arbeitsablauf auf dem Display in den jeweiligen optimalen Arbeitsschritten wiedergegeben wird. Die Bestückung kann dem individuellen Arbeitstempo angepaßt werden und in der dem Arbeitsprozess förderlichen, besten Reihenfolge abgewickelt werden. Hinzu kommt, daß die einmal mit dem System vertraute Bedienungsperson ohne längere Anlernzeiten mit anderen Bestückungsarbeiten betraut werden kann.

Gegenüber der Technik des bekannten Auflichtverfahrens ist zunächst die kostengünstigere Geräteausstattung eines Arbeitsplatzes hervorzuheben. Außerdem werden die Nachteile des Auflichtverfahrens, nämlich die Tatsache, daß die Hinweise zum Bestückungsvorgang sich nur auf wenige Symbole (Striche bzw. Punkte) beschränken und bei der Montage von Bauelementen die Positionsanzeige verdeckt wird, vermieden. Bei den heute verwendeten vielbeinigen Bauelementen (z.B. IC's, Steckerleisten) ist es von besonderer Wichtigkeit, der Bedienungsperson die Konturen mitzuteilen; diese Möglichkeit ist nur bei Verwendung eines Displays gegeben.

Das erfindungsgemäß vorgeschlagene Verfahren beinhaltet eine Vereinfachung des Arbeitsablaufs beim Zusammenbau von elektronischen und mechanischen Baugruppen durch konsequente Anwendung der Mikrocomputertechnik. Im Vergleich mit den bekannten Auflichtverfahren ist vor allem die höhere Wirtschaftlichkeit und einfachere technische Handhabung hervorzuheben.

Mit der Erfindung wird ein Verfahren angeboten, welches es dem Auge nicht nur erleichtert, den jeweiligen Bestückungsort zu finden, sondern bei dem auch der Fortgang der Arbeiten auf dem Display im Detail verfolgt werden kann. Das menschliche Auge ermüdet erfahrungsgemäß weniger schnell, wenn es zusammenhängende Figuren betrachtet. Dagegen läßt die Konzentration bei den bekannten Verfahren, wegen der Orientierung auf einen Punkt, rasch nach. Im Gegensatz zu sämtlichen bekannten Verfahren ist durch das Prinzip des sich aufbauenden Bildes jederzeit eine Kontrollmöglichkeit der vorangegangenen Arbeitsschritte möglich.

Für den Anwendungsfall der Bestückung von Leiterplatten entsteht in fertigungstechnisch geeigneter Reihenfolge auf dem Bildschirm der Gesamtbestückungsplan in der Art, daß als erstes Teilbild die Leiterplatte mit allen für die Montage benötigten Bohrungen abgebildet wird und bis zum Ende der Bestückung als Hintergrundabbildung die dringend erforderliche Orientierung auf der Leiterplatte ermöglicht. In der weiteren Folge werden diesem Bild nacheinander die Umrißbilder der zu bestückenden Bauteile hinzugefügt, dabei treten bereits erledigte Positionen durch geringere Helligkeit in den Hintergrund, während die aktuelle Position deutlich heller dargestellt wird.

Zur verwechselungsfreien Kennzeichnung von Bauteilen können farbliche und textliche Zusatzinformationen an beliebiger Stelle auf dem Bildschirm angezeigt werden, wobei besonders bei längeren Texten diese an freien Stellen des Bildschirms placiert sind und durch eine Bezugslinie mit dem zu erläuternden Bauteil in Verbindung stehen.

Der Abruf neuer Bestückungspositionen durch Betätigen eines Schalters löst über den Grafik-Mikrocomputer anhand der im Speicher aufgerufenen Informationen die stets neue Vorzeichnung des aktuellen Bauteils aus, wobei gleichzeitig mit ergänzenden Hinweisen auf dem Display die Bereitstellung des dazugehörigen Bauteils erfolgt. Durch die bei Grafik-Mikrocomputern bekannte Erzeugung von Bildern und Text durch Aneinanderfügen von Bildpunkten/Pixeln mit entsprechend hoher Auflösung wird der Forderung enger Rasterung bei noch weiter steigender Packungsdichte auf der Leiterplatte Rechnung getragen.

Für die weiteren Anwendungsfälle des erfindungsgemäß vorgeschlagenen Verfahrens ist die Möglichkeit der perspektivischen und bewegten Darstellung von bildlichen Informationen durch die Anwendung der Mikrocomputertechnik gegeben. Weiter wird dadurch zur Vereinfachung und Zeiteinsparung bei der Programmierung die direkte Verarbeitung von Daten aus vorgeordneten Computeranlagen, Digitalisierungstabletts und dergleichen erst sinnvoll, wenn nicht überhaupt erst möglich. Eine lückenlose Archivspeicherung sämtlicher Daten für Fertigung, Qualitätsprüfung, Materialwirtschaft etc. in Form von Plänen bzw. Listen aller Art ist auf besonders vorteilhafte Weise gewähr-

- 4 -

0064660

leistet. Die Modifizierung/Änderung der Anzeigenabläufe und Arbeitsschritte ist ebenso wie das Anwendungsspektrum äußerst flexibel und auch darin den bekannten Verfahren überlegen. So ist eine Rückkoppelung zur Qualitätskontrolle möglich, es können beim ersten Auftreten von Serienfehlern sofort zusätzliche Informationen eingefügt werden.

Eine Erweiterung im Hinblick auf die Überwachung der Montage bietet die Einmischung eines Kamera-Bildes vom Arbeitsobjekt in das symbolhafte Bild der Beschreibung des Arbeitsablaufs auf dem Display. Mit dieser Methode ist jederzeit eine direkte Kontrollmöglichkeit über den aktuellen Stand der Arbeiten gegeben. Weiter kann mit geeigneter Optik das Symbolbild des Displays - nach Art des Bestückungsaufdrucks bei Leiterplatten - auf das Arbeitsobjekt projiziert werden. Damit wäre auch die direkte Anzeige des Arbeitsablaufs auf der Leiterplatte bzw. Baugruppe für bestimmte Anwendungsbereiche möglich.

Die Programmierung des Bestückungsablaufs ist durch umfassende Firmware auf wenige Tätigkeiten beschränkt; die Steuerung erfolgt über einen Grafik-Mikrocomputer. Zur Programmierung eines Bestückungsvorgangs wird ein Kennungssymbol mit einem Steuerungsknüppel bzw. einer Tastatur auf die jeweilige Bestückungsposition eingestellt oder diese Position mit einem Lichtgriffel abgetastet. Diese Daten können gleichermaßen von vorgeordneten Computeranlagen übernommen werden. Die Programme werden auf Digitalkassetten oder anderen Speichermedien gespeichert.

Die erfindungsgemäße Einrichtung ist mit einer automatischen Zufuhr von Bauelementen ausgerüstet, welche ebenfalls vom Programm gesteuert wird. Die Bauteilezuführung erfolgt ergonomisch optimal, die Teile können in unmittelbarer Nähe der zu bestückenden Trägerplatte entnommen werden und befinden sich im Blickfeld der die Montage durchführenden Bedienungsperson. Die automatische Bauteilezufuhr kann bei einfachen Bestückungsvorgängen derart mit der Leuchtanzeige auf der Trägerplatte synchronisiert sein, daß die Bedienungsperson während des Einsetzens eines Bauteils mit der einen Hand bereits das für die folgende Bestückungsposition bestimmte Bauelement mit der anderen Hand entnehmen kann.

Von Vorteil ist bei dem erfindungsgemäß vorgeschlagenen Verfahren, daß für die Bestückung kleinerer Leiterplatten eine Lupe, schwenkbar und ergonomisch installiert, zu Hilfe genommen werden kann. Diese ist bei allen bekannten Auflicht- bzw. Projektionsverfahren wegen der Ablenkung des Lichtstrahls nicht einsetzbar.

## Patentansprüche

1. Verfahren zur rationellen, kontrollierten Steuerung von Arbeitsabläufen beim Zusammenbau von elektronischen und mechanischen Baugruppen, insbesondere der Bestückung von Schaltungsträgerplatinen, durch Abbildung von Leuchtsymbolen entsprechend den Umrissen bzw. den Befestigungspunkten der Bestückungsteile auf dem Display eines Grafik-Mikrocomputers. Der Zusammenbau erfolgt im Blickfeld von Arbeitsobjekt und Display, indem losgelöst von der bekannten direkten Anzeige auf der Baugruppe nach einem elektronisch aus Teilbildern vorgezeichneten Bestückungsplan (sich aufbauendes Bild) montiert wird.

2. Verfahren nach Anspruch 1, dadurch gekennzeichnet, daß als Display die einfarbige oder mehrfarbige Elektronenstrahlröhre (Bildröhre), das Plasmadisplay oder dergleichen (flacher Bildschirm in seinen Varianten) für die gemischte Darstellung von Bildern, beliebigen geometrischen Figuren und Text zur Anwendung kommt.

3. Verfahren nach Anspruch 1 und 2, dadurch gekennzeichnet, daß der Bedienungsperson nach dem Einsetzen eines Bauelements das Aufsuchen des Bestückungsorts für das als nächstes einzubauende Bauelement erleichtert wird, indem eine Leuchtspur zum folgenden Bestückungsort gerichtet wird bzw. der neue Bestückungsort jeweils heller aufleuchtet als alle bereits bestückten Positionen (Prinzip des sich aufbauenden Bildes).

4. Verfahren nach Anspruch 1 bis 3, dadurch gekennzeichnet, daß die Montage am Display durch Einmischung eines analogen oder digital aufbereiteten Kamerabildes vom Arbeitsobjekt in die symbolbildliche Darstellung des Bestückungsablaufs, überwacht werden kann.

5. Verfahren nach Anspruch 1 bis 4, dadurch gekennzeichnet, daß mit einer geeigneten Optik dasSymbolbild des Displays auf das Arbeitsobjekt projiziert werden kann.

6. Verfahren nach Anspruch 1 bis 5, dadurch gekennzeichnet, daß die Leuchtbilder (Symbole) und Leuchtspuren in ihrer Beleuchtungsstärke moduliert werden können; beispielsweise pulsierend aufleuchten und in jeder beliebigen Geschwindigkeit bewegt werden können.

7. Einrichtung zur Durchführung des Verfahrens nach einem der Ansprüche 1 bis 6, dadurch gekennzeichnet, daß eine Halterung bzw. ein Lötrahmen für einzelne oder mehrere zu bestückende Trägerplatten in geringem Abstand vom Display (Bestückungsort und Display sind in einem Blickfeld) fest installiert sind.

8. Einrichtung nach Anspruch 7, dadurch gekennzeichnet, daß der Bestückungsvorgang mit einem Kennungssymbol durch einen Steuerknüppel bzw. eine Tastatur auf die jeweilige Bestückungsposition eingestellt wird, diese Position mit einem Lichtgriffel oder dergleichen abgetastet wird bzw. die Daten vorgeordneter Computeranlagen eingelesen werden.

9. Einrichtung nach Anspruch 7 und 8, dadurch gekennzeichnet, daß die Bestückungspositionen der Trägerplatte digital gespeichert werden und der Bestückungsvorgang von einem Grafik-Mikrocomputer gesteuert wird.

10. Einrichtung nach einem der Ansprüche 7 bis 9, dadurch gekennzeichnet, daß eine automatische, programmgesteuerte Zuführung von Bauelementen in unmittelbarer Nähe der zu bestückenden Trägerplatte und damit im Blickfeld der die Montage durchführenden Bedienungsperson erfolgt.

11. Einrichtung zur Durchführung des Verfahrens nach einem der Ansprüche 1 bis 7, dadurch gekennzeichnet, daß der Bestückungsvorgang durch eine fest installierte, schwenkbare Lupe überwacht werden kann; die Arbeit bei der Bestückung von Miniaturleiterplatten wird dadurch erleichtert, wenn nicht sogar erst ermöglicht. Die Anzeige auf dem Display erfolgt entsprechend dem Vergrößerungsfaktor der Lupe und damit visuell im Maßstab 1 : 1.